# EUROPEAN PATENT SPECIFICATION

(11) **EP 4 156 260 B1**
(45) Date of publication and mention of the grant of the patent: **15.04.2026**
(21) Application number: 22184090.3
(22) Date of filing: 11.07.2022
(51) Int. Cl.: H01L 23/31, H01L 23/532, H01L 23/00, H01L 21/768

(54) **TOPOLOGICAL CRACK STOP (TCS) PASSIVATION LAYER**
PASSIVIERUNGSSCHICHT MIT TOPOLOGISCHEM RISSSTOP
COUCHE DE PASSIVATION AVEC ARRÊT TOPOLOGIQUE DE FISSURES (TCS)

(30) Priority: 24.09.2021 US 202117485156
(43) Date of publication of application: 29.03.2023
(73) Proprietor: Intel Corporation, Santa Clara, CA 95054 (US)
(72) Inventor: JAVVAJI, Vishal, Hillsboro, 97124 (US); PELTO, Christopher M., Beaverton, 97006 (US); ANTARTIS, Dimitrios, Hillsboro, 97123 (US); RAORANE, Digvijay, Chandler, 85248 (US); O'DAY, Michael P., Phoenix, 85048 (US); CHOI, Seung-June, Portland, 97229 (US)
(74) Representative: Goddar, Heinz J.

(56) References cited:
- CN-A- 112 582 398
- US-A1- 2009 032 909
- US-A1- 2011 278 736
- US-A1- 2015 371 956
- US-A1- 2019 304 929

## Description

### TECHNICAL FIELD

Embodiments of the disclosure are in the field of semiconductor packages and, in particular, the methods and systems a topological crack stop (TCS) passivation layer for integrated circuits.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and state-of-the-art fabrication processes may limit the possibility to further extend them into the sub-10 nm range. Consequently, fabrication of the functional components needed for future technology nodes may require the introduction of new methodologies or the integration of new technologies in current fabrication processes or in place of current fabrication processes.
US 2009/032909 A1 describes a structure which includes a semiconductor substrate, a transistor on the semiconductor substrate, and N interconnect layers on top of the semiconductor substrate, N being a positive integer. The transistor is electrically coupled to the N interconnect layers. The structure further includes a first dielectric layer on top of the N interconnect layers and P crack stop regions on top of the first dielectric layer, P being a positive integer. The structure further includes a second dielectric layer on top of the first dielectric layer. Each crack stop region of the P crack stop regions is completely surrounded by the first dielectric layer and the second dielectric layer. The structure further includes an underfill layer on top of the second dielectric layer. The second dielectric layer is sandwiched between the first dielectric layer and the underfill layer. US 2019/304929 A1 describes an integrated circuit (IC) structure which includes an active area of the IC structure insulator positioned over a substrate. The active area includes an interconnection structure comprised of a first plurality of levels. Each of the interconnect structure levels includes an interlayer dielectric (ILD) layer, a barrier layer disposed over the ILD and a conductor metal layer over the barrier layer. The structure also includes a crack stop area which includes a crack stop structure having a second plurality of levels. The interconnect and crack stop structures have an equal number of levels. A third plurality of the crack stop structure levels include a high modulus layer unique to the respective crack stop structure level as compared to the corresponding interconnect structure level. In another aspect of the invention, a method for fabricating the structure is described.
CN 112 582 398 A describes a method and semiconductor device including a substrate having one or more semiconductor devices. The device further includes a first passivation layer disposed over the one or more semiconductor devices. The device may further include a metal-insulator-metal (MIM) capacitor structure formed over the first passivation layer. In addition, the device may further include a second passivation layer disposed over the MIM capacitor structure. In various examples, a stress-reduction feature is embedded within the second passivation layer. In some embodiments, the stress-reduction feature includes a first nitrogen-containing layer, an oxygen-containing layer disposed over the first nitrogen-containing layer, and a second nitrogen-containing layer disposed over the oxygen containing layer. The invention also relates to a semiconductor device and a forming method thereof.
US 2011/278736 A1 describes a semiconductor device that has a temporary carrier. A semiconductor die is oriented with an active surface toward, and mounted to, the temporary carrier. An encapsulant is deposited with a first surface over the temporary carrier and a second surface, opposite the first surface, is deposited over a backside of the semiconductor die. The temporary carrier is removed. A portion of the encapsulant in a periphery of the semiconductor die is removed to form an opening in the first surface of the encapsulant. An interconnect structure is formed over the active surface of the semiconductor die and extends into the opening in the encapsulant layer. A via is formed and extends from the second surface of the encapsulant to the opening. A first bump is formed in the via and electrically connects to the interconnect structure.
The invention is set forth in the independent claims. Embodiments of the invention are described in the dependent claims.

### BRIEF DESCRIPTION OF THE DRAWINGS

Figure 1 is a cross-section view of an integrated circuit (IC) structure suitable for incorporation into an advanced driver-assistance systems (ADAS) die and a cause of failures in the IC.
Figure 2A is a cross-section view of an integrated circuit (IC) structure having a topological crack stop (TCS) passivation layer in accordance with examples not according to the invention.
Figures 2B and 2C are cross-section scanning electron microscope (SEM) view of an integrated circuit (IC) structure further illustrating the topological crack stop features in accordance with examples not according to the invention.
Figures 3A - 3G are diagrams illustrating various embodiments of the topological crack stop features.
Figures 4A-4E illustrates cross-section views showing a fabrication process for ICs with TCS features.
Figure 5 is a cross-sectional side view of an integrated circuit (IC) device assembly that may include one or more transistors with topological crack stop features, in accordance with one or more of the embodiments disclosed herein.
Figure 6 illustrates a computing device in accordance with one implementation of the disclosure.

### DESCRIPTION OF THE EMBODIMENTS

A topological crack stop (TCS) passivation layer for integrated circuits is described. In the following description, numerous specific details are set forth, such as specific material and tooling regimes, in order to provide a thorough understanding of embodiments of the present disclosure. It will be apparent to one skilled in the art that embodiments of the present disclosure may be practiced without these specific details. In other instances, well-known features, such as single or dual damascene processing, are not described in detail in order to not unnecessarily obscure embodiments of the present disclosure. Furthermore, it is to be understood that the various embodiments shown in the Figures are illustrative representations and are not necessarily drawn to scale. In some cases, various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back-end-of-line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments described herein are directed to structures and architectures for fabricating a topological crack stop (TCS) passivation layer for integrated circuits. Embodiments may include or pertain to integrated circuits and system-on-chip (SoC) technologies for applications including but not limited to, advanced driver-assistance systems (ADAS).

There is a need for advanced driver-assistance systems (ADAS) chips to have significant reliability capability. Integrated circuits have been influencing a revolution in the field of autonomous vehicles, and semiconductor chips have played central role in enabling this capability. For example, these chips are the brains behind AI that drives such autonomous vehicles. Since an average user utilizes a given vehicle for 10 years, it is pertinent that these chips deliver the performance during that lifetime, particularly with respect to thermal mechanical properties.

The reliability performance for an ADAS chip is tested using temperature cycling (TC) stress, which increases applied stress to the chip to accelerate to identify potential fail mechanisms. Typically, the ADAS chip is required last for at least PC (pre-conditioning) plus 1000 thermal cycles (TCB). However, actual reliability performance data on test vehicles that mimic such chips show fails occurring in the chips significantly before 1000 thermal cycles (e.g., at 150-450 cycles). These fails lead to electrical discontinuity in the integrated circuit rendering the product inoperable.

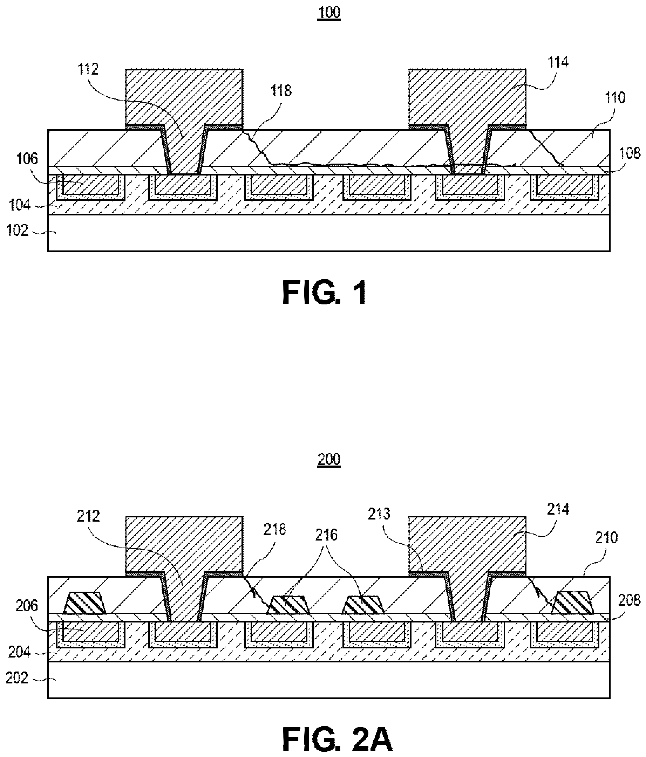

To provide further context, Figure 1 is a cross-section view of an integrated circuit (IC) structure suitable for incorporation into an ADAS die and a cause of failures in the IC. The IC 100 includes a substrate 102 that forms a die package and one or more first level interconnects (FLI) 106 embedded in an underfill (UF) 104, which is typically an epoxy. An etch stop layer 108 is over the FLI 106 and a passivation layer 110 or an interlayer dielectric (ILD) layer is over the etch stop layer 108. A plurality of vias 112 are formed through the passivation layer 110 and a plurality of contacts 114, such solder bumps, are on the passivation layer 110 in contact with the vias 112 to connect with the FLI 106.

Figure 1 shows that a cause of failure in the IC 100. The technical problem is die passivation cracks 118 that primarily originate at the intersection between sidewalls of the contacts 114 and the passivation layer 110 and continue down through the passivation layer 110 at an angle (e.g., approximately 45°). The die passivation cracks 118 hit the etch stop layer 108, and because the etch stop layer 108 is planar, the die passivation cracks 118 propagate (float) horizontally along the etch stop layer 108 and into or through the neighboring via 112, causing electrical openings that result in via failure.

Various solutions proposed to solve this issue include: i) use of PI (polyimide) as passivation material, ii) use of smaller die for the product, and iii) removal of a lid from the package. Each solution, however, has disadvantages. For example, the disadvantage of use of PI as passivation material is that current fabrication chemical disposal facilities are not compatible with PI, and it is prohibitively expensive to implement this solution path.

The use of smaller die for the product may reduce thermomechanical stress and hence provide better reliability performance, but typically means less number of features available for designers. Current ADAS chips require server like chips to process vehicle data in real-time, and hence less features makes smaller dies undesirable in ADAS products.

And although lidded products have higher thermomechanical stress than unlidded products because lids constrain the substrate and transfer stress to the die from the substrate, removal of the also leads to reduction in heat conduction from other parts. As a result, the parts runs hot and delivers very low performance.

In accordance with one or more embodiments described herein, integrated circuits suitable for ADAS applications are provided with a crack-arresting feature referred to herein as a topological crack stop (TCS) layer, which arrests crack propagation. The TCS effectively prevents via fails and enables the IC to increase reliability performance to greater than 1000 thermal cycles. Increased reliability performance enables the IC to be used in products in more demanding segments that need stringent reliability requirements such as ADAS, military, etc., while having lower defects per million (DPM). The TCS feature size, pitch and layout can all be tailored and optimized per the product's BP pitch, circuit performance and reliability needs. Due to this high scalability/tunability of TCS features, the TCS can be integrated into any future technology nodes easily with minimal yield risk. In embodiments, the TCS features can be reused to create functional circuit elements (MIM capacitors, inductors, precision resistors) or process integration aiding features (alignment marks, PRS marks, catch-cups, adhesion improvement to passivation/UF layers).

Figure 2A is a cross-section view of an integrated circuit (IC) structure having a topological crack stop (TCS) passivation layer in accordance with the disclosed examples. The IC 200 includes a substrate 202 that forms a die package and one or more first level interconnects (FLI) 206 embedded in an underfill 204, typically an epoxy over the substrate 202. An etch stop layer 208 is over the FLI 206 and a passivation layer 210 or an interlayer dielectric (ILD) is over the etch stop layer 208. A plurality of vias 212 are formed through the passivation layer 210, and a plurality of contacts 214, such solder bumps, are on the passivation layer 210 in contact with the vias 212 to connect with the FLI 206. Optionally, a barrier layer or under bump metallization 213 may be present along sidewalls of the vias 212 and along a top surface of the passivation layer 210 under the contacts 214, as depicted.

In accordance with the disclosed examples, topological crack stop (TCS) features 216 are formed in the passivation layer 210 and on a top surface of the etch stop layer 208. The TCS features 216 function to arrest a die passivation crack 218 that enters the passivation layer 210 and prevent the die passivation crack 218 from propagating horizontally along the etch stop layer 208 into one of the vias 212. The TCS features 216 effectively prevents via fails and provides the IC 200 with increased reliability performance.

In one example, the passivation layer 210 may comprise an inorganic dielectric materials nitride (e.g., SiN), and the TCS features 216 may comprise an oxide. In examples, the TCS features 216 can comprise various inorganic dielectric materials (e.g., SiN, SiC, SiO₂, etc.), or the TCS features 216 can comprise organic materials (e.g., PI, PBO, WPR) or combination of thereof. In another example, the TCS features 216 can comprise a metal material (e.g., Cu, Al, W, Ni, etc.) or a combination of metals.

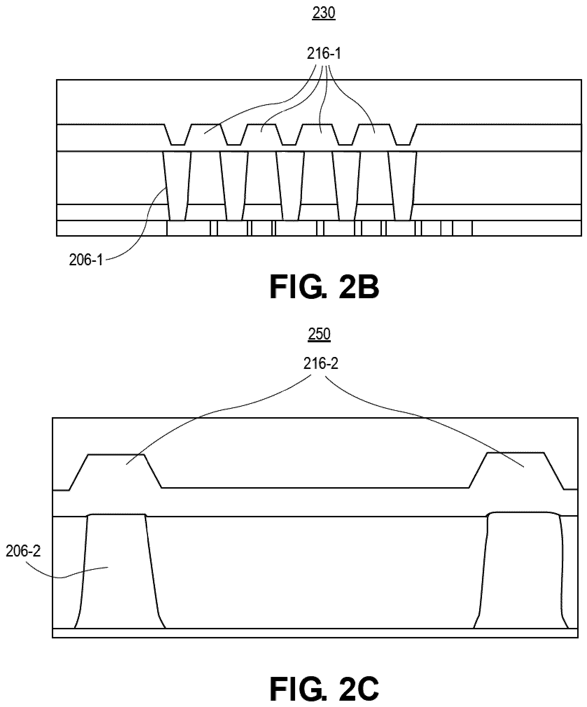

Figures 2B and 2C are cross-section scanning electron microscope (SEM) view of an integrated circuit (IC) structure further illustrating the topological crack stop features in accordance with the disclosed examples. Figures 2B and 2C show IC structures 230 and 250, respectively, right after patterning first level interconnects (FLIs) 206-1 and 206-2 and TCS features 216-1 and 216-2, but prior to via formation. Figure 2B shows the IC structure 230 has tight pitch, location and feature size for both the FLIs 206-1 and the TCS features 216-1. Figure 2C shows the IC structure 250 has larger pitch, location and feature size for both the FLIs 206-2 and the TCS features 216-2. In both examples, the same reticle can be used to pattern both the FLIS and the TCS features. That is, in Figure 2B the same reticle can be used to pattern the FLIs 206-1 and the TCS features 216-1. In Figure 2C the same reticle can be used to pattern the FLIs 206-2 and the TCS features 216-2. Thus, there can be a correlation between a pitch and location of the FLIs 206 and a pitch and location of the TCS features 216. In other examples, the TCS features 216-1 and 216-2 can be patterned independent of the FLIs 206-1 and 206-2.

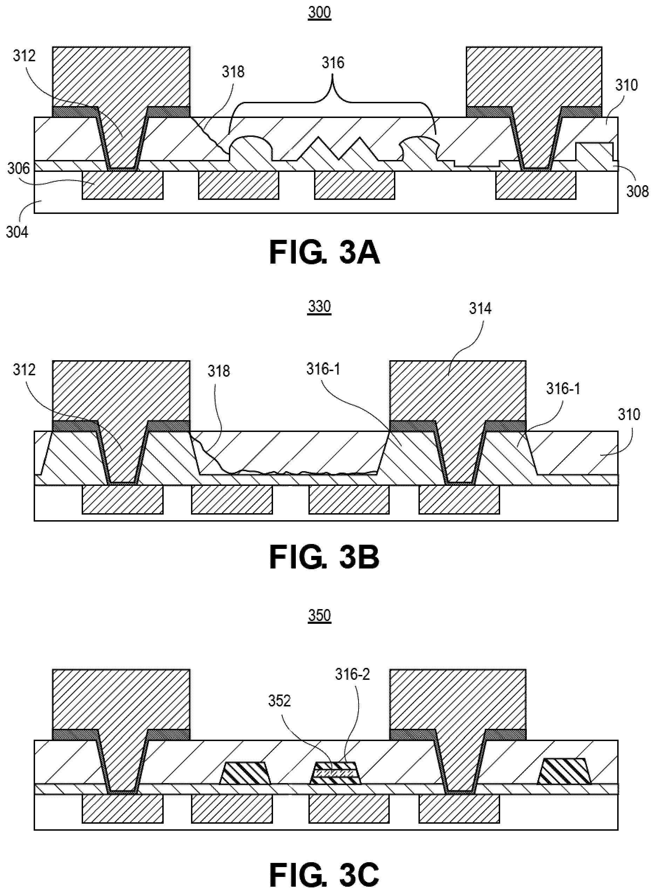

Figures 3A - 3G are diagrams illustrating various examples of the topological crack stop features. Figure 3A is a cross-section view of an integrated circuit (IC) structure 300 illustrating different shapes for the topological crack stop (TCS) features. The default shape for the TCS features 316 may be square or rectangular, but may further include domed, saw-toothed, recess domed, trenched, or a combination thereof. The selected shape may be customized for the application and materials used. Whichever shape is selected, a die passivation crack 318 entering the passivation layer 310 is arrested by the first TCS feature 316 the die passivation crack 318 encounters, as shown.

In one embodiment, the height of the TCS features 316 is less than the height of the passivation layer 310. In another embodiment, the height of the TCS features 316 is approximately one-half the height of the passivation layer 310. In yet another embodiment, the height of the TCS features 316 is approximately equal to height of the passivation layer 310. In yet another embodiment, the TCS features 316 may span multiple layers of the IC 300, including extending below the etch stop layer 308 to the FLI 306.

Figure 3A further shows that despite the selected shape, at least a portion of the TCS features 316 may be spaced apart between neighboring sets of vias 312.

Figure 3B is a cross-section view of an integrated circuit (IC) structure 330 showing an island example for the TCS features 316. In the island embodiment, at least a portion of the TCS features 316-1 are located adjacent and in contact with the vias 312 directly under corresponding contacts 314. In this example, the vias 312 are protected by the "island" TCS features 316-1. A die passivation crack 318 entering the passivation layer 310 at one contact 314 and TCS feature 316-1 pair (left) may propagate through the passivation layer 310, but is stopped by the adjacent island TCS feature 316-1 of the next contact 314 (right).

Figure 3C is a cross-section view of an integrated circuit (IC) structure 350 showing that in the invention, at least one of the TCS features 316-2 incorporates an embedded metal-insulator-metal (MIM) 352. Examples of a MIM 352 may a diode, capacitor and the like.

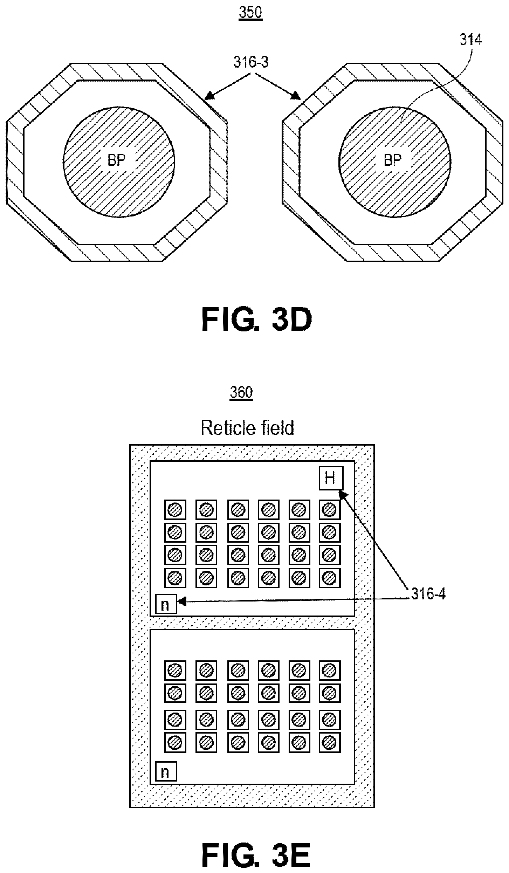

Figure 3D is a top view an integrated circuit (IC) structure 350 showing an example where the TCS features 316-3 are configured as inductor elements. In this example, the TCS features 316-3 surround a base of one or more of the vias 312, which are hidden in this view. As shown, a diameter of the TCS features 316-3 is greater than a diameter of the corresponding contacts 314 located over the underlying vias 312.

Figure 3E is a top view an integrated circuit (IC) structure 360 showing an example where the TCS features 316-4 are configured and used as in-die alignment features 316-4 within a reticle field for example. Alignment marks typically provide means for registering a photomask for subsequent photolithography steps. In the example, the TCS features 316-4 are shown as PRS alignment/registration marks. In one example, the TCS features 316-4 may comprise copper above metal 1, but are created as part of other TCS features described above and made visible.

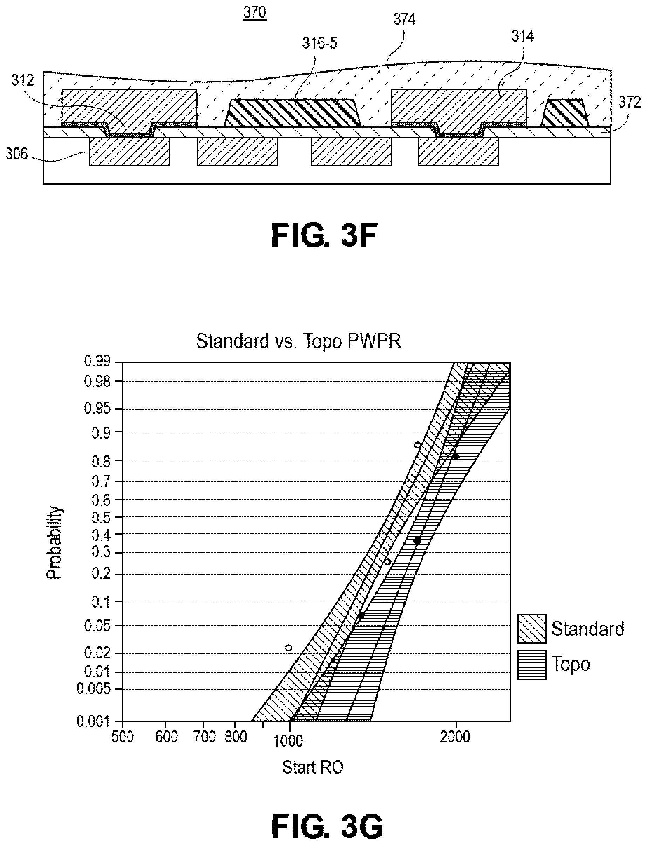

Figure 3F is a cross-section view of an integrated circuit (IC) structure 370 showing that in another example, at least one of the TCS features 316-5 are configured and used as underfill adhesion promoters. In this example, the IC structures 370 includes an inorganic passivation layer 372 over the FLI 306 and an underfill material 374 over the contacts 314 and the inorganic passivation layer 372. In cases where underfill material 374 does not adhere well to the inorganic passivation layer 372, an organic TCS feature 316-5 can be added to enhance the adhesion to underfill material 374 and improving overall underfill-die adhesion.

Figure 3G shows a reliability performance chart for ICs that include an organic planar passivation layer (PWPR) with topological (Topo) crack stop features versus standard ICs that do not include TCS features. The X-axis shows the number of test cycles and the Y-axis is the probability of fails during thermal testing. The ICs that include the TCS features have a distribution that is shifted to right indicating a greater number of thermal cycles and reliability. In this example, the ICs that include the TCS features provide approximately 200 cycles of improvement compared to the standard ICs before a failure is likely.

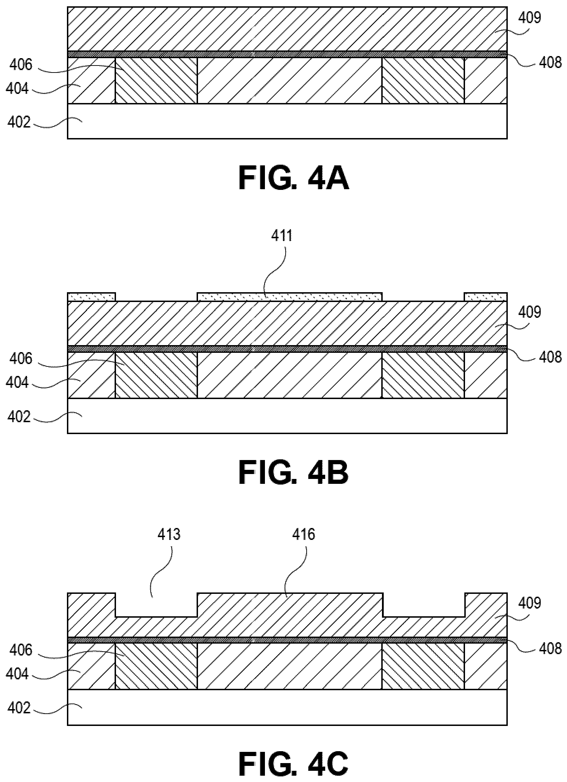

Figures 4A-4E illustrates cross-section views showing a fabrication process for ICs with TCS features. Alternate processes can also be developed to achieve similar TCS features. Figure 4A illustrates that the fabrication process begins with a structure 400 comprising a first level interconnects 406 embedded in an underfill 404 over a substrate 402. An optional etch stop layer 408 is over the FLI 406. The process may being by forming and a TCS layer 409 over the etch stop layer 408. In this embodiment, the TCS layer 409 comprises a nitride and may have a thickness of approximately 2 µm to avoid wafer bow.

Figure 4B illustrates the fabrication process after lithography forms a TCS layer pattern 411 on the TCS layer 409. In this example, first layer interconnect reticle may be reused to form the TCS layer pattern as example (e.g., see FIGS. 2B and 2C), but a dedicated and reliability fail mode optimized Topo mask can also be used.

Figure 4C illustrates the fabrication process after trenches 413 are etched into the TCS layer 409 with then opening in TCS layer pattern 411 to form the TCS features 416.

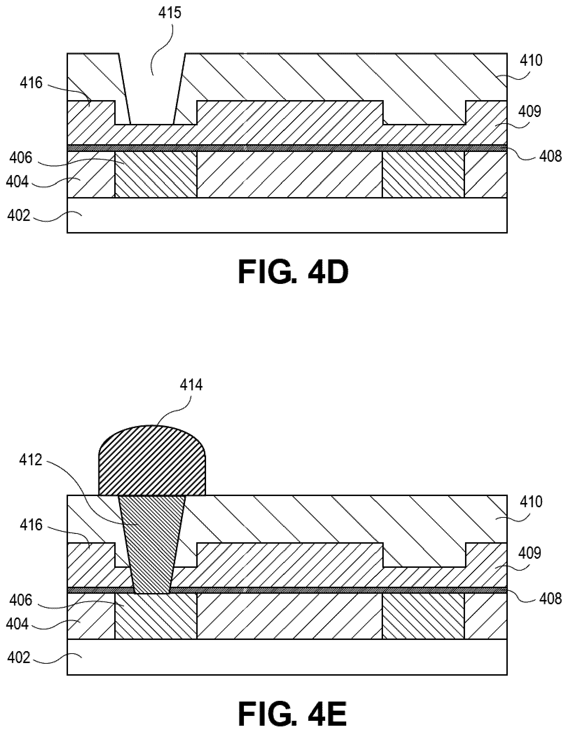

Figure 4D illustrates the fabrication process after patterning and deposition of a passivation layer 410 over the TCS layer 409, and etching of via trenches 415 in the passivation layer 410. In one embodiment, the via trenches 415 may have a depth of approximately 1.5 µm.

Figure 4E illustrates the fabrication process after via metallization is performed in the via trenches 415 to form vias 412, and after contact metallization is performed over the vias 412 to form contacts 414.

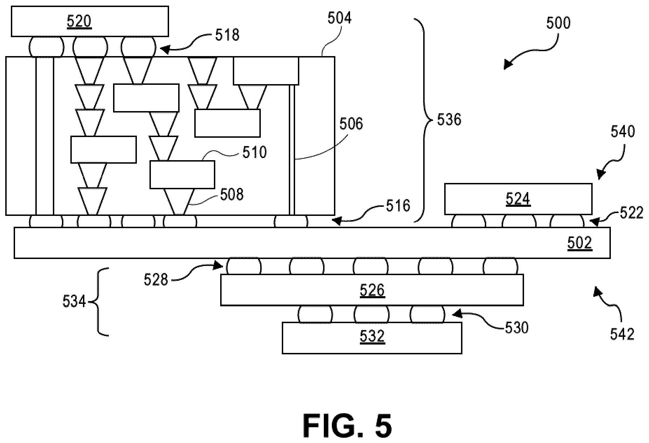

It is to be appreciated that the structures resulting from the above exemplary processing schemes may be used in a same or similar form for subsequent processing operations to complete device fabrication, such as for an ADAS device. As an example of a completed device, Figure 5 illustrate a cross-sectional view of a non-planar integrated circuit structure as taken along a gate line, in accordance with an embodiment of the present disclosure.

Figure 5 is a cross-sectional side view of an integrated circuit (IC) device assembly that may include one or more transistors with topological crack stop features, in accordance with one or more of the embodiments disclosed herein.

Referring to Figure 5, an IC device assembly 500 includes components having one or more integrated circuit structures described herein. The IC device assembly 500 includes a number of components disposed on a circuit board 502 (which may be, e.g., a motherboard). The IC device assembly 500 includes components disposed on a first face 540 of the circuit board 502 and an opposing second face 542 of the circuit board 502. Generally, components may be disposed on one or both faces 540 and 542. In particular, any suitable ones of the components of the IC device assembly 500 may include a number of transistor architectures utilizing IC structures with topological crack stop features, such as disclosed herein.

In some embodiments, the circuit board 502 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 502. In other embodiments, the circuit board 502 may be a non-PCB substrate.

The IC device assembly 500 illustrated in Figure 5 includes a package-on-interposer structure 536 coupled to the first face 540 of the circuit board 502 by coupling components 516. The coupling components 516 may electrically and mechanically couple the package-on-interposer structure 536 to the circuit board 502, and may include solder balls, male and female portions of a socket, an adhesive, an underfill material, and/or any other suitable electrical and/or mechanical coupling structure.

The package-on-interposer structure 536 may include an IC package 520 coupled to an interposer 504 by coupling components 518. The coupling components 518 may take any suitable form for the application, such as the forms discussed above with reference to the coupling components 516. Although a single IC package 520 is shown, multiple IC packages may be coupled to the interposer 504. It is to be appreciated that additional interposers may be coupled to the interposer 504. The interposer 504 may provide an intervening substrate used to bridge the circuit board 502 and the IC package 520. The IC package 520 may be or include, for example, a die, or any other suitable component. Generally, the interposer 504 may spread a connection to a wider pitch or reroute a connection to a different connection. For example, the interposer 504 may couple the IC package 520 (e.g., a die) to a ball grid array (BGA) of the coupling components 516 for coupling to the circuit board 502. In the embodiment illustrated in Figure 5, the IC package 520 and the circuit board 502 are attached to opposing sides of the interposer 504. In other embodiments, the IC package 520 and the circuit board 502 may be attached to a same side of the interposer 504. In some embodiments, three or more components may be interconnected by way of the interposer 504.

The interposer 504 may be formed of an epoxy resin, a fiberglass-reinforced epoxy resin, a ceramic material, or a polymer material such as polyimide. In some implementations, the interposer 504 may be formed of alternate rigid or flexible materials that may include the same materials described above for use in a semiconductor substrate, such as silicon, germanium, and other group III-V and group IV materials. The interposer 504 may include metal interconnects 510 and vias 508, including but not limited to through-silicon vias (TSVs) 506. The interposer 504 may further include embedded devices, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio-frequency (RF) devices, power amplifiers, power management devices, antennas, arrays, sensors, and microelectromechanical systems (MEMS) devices may also be formed on the interposer 504. The package-on-interposer structure 536 may take the form of any of the package-on-interposer structures known in the art.

The IC device assembly 500 may include an IC package 524 coupled to the first face 540 of the circuit board 502 by coupling components 522. The coupling components 522 may take the form of any of the embodiments discussed above with reference to the coupling components 516, and the IC package 524 may take the form of any of the embodiments discussed above with reference to the IC package 520.

The IC device assembly 500 illustrated in Figure 5 includes a package-on-package structure 534 coupled to the second face 542 of the circuit board 502 by coupling components 528. The package-on-package structure 534 may include an IC package 526 and an IC package 532 coupled together by coupling components 530 such that the IC package 526 is disposed between the circuit board 502 and the IC package 532. The coupling components 528 and 530 may take the form of any of the embodiments of the coupling components 516 discussed above, and the IC packages 526 and 532 may take the form of any of the embodiments of the IC package 520 discussed above. The package-on-package structure 534 may be configured in accordance with any of the package-on-package structures known in the art.

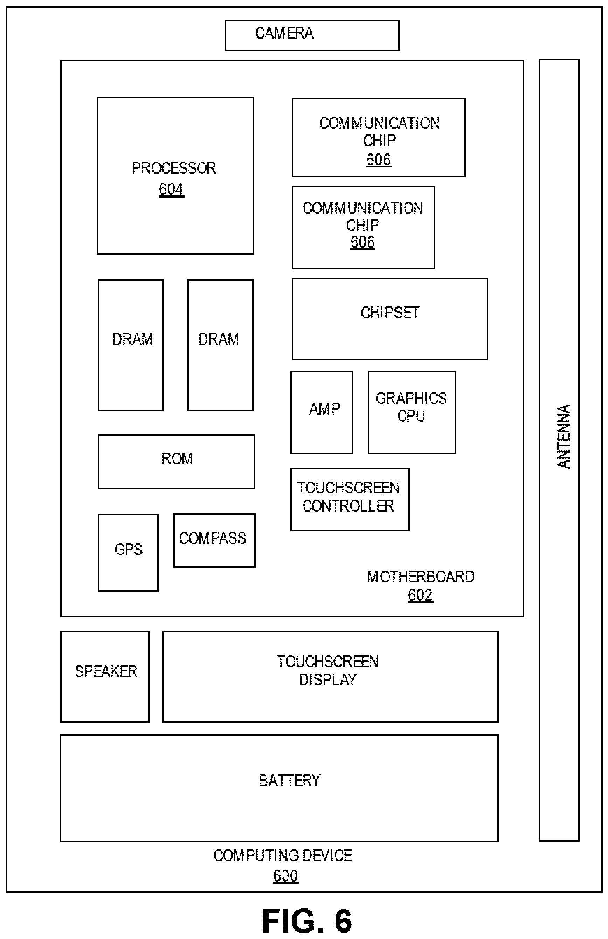

Figure 6 illustrates a computing device 600 in accordance with one implementation of the disclosure. The computing device 600 houses a board 602. The board 602 may include a number of components, including but not limited to a processor 604 and at least one communication chip 606. The processor 604 is physically and electrically coupled to the board 602. In some implementations the at least one communication chip 606 is also physically and electrically coupled to the board 602. In further implementations, the communication chip 606 is part of the processor 604.

Depending on its applications, computing device 600 may include other components that may or may not be physically and electrically coupled to the board 602. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 606 enables wireless communications for the transfer of data to and from the computing device 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing device 600 includes an integrated circuit die packaged within the processor 604. In some implementations of the disclosure, the integrated circuit die of the processor includes one or more transistor architectures utilizing IC structures with topological crack stop features, in accordance with implementations of embodiments of the disclosure. The term "processor" may refer to any device or portion of a device that processes electronic data from registers and/or memory to transform that electronic data into other electronic data that may be stored in registers and/or memory.

The communication chip 606 also includes an integrated circuit die packaged within the communication chip 606. In accordance with another implementation of embodiments of the disclosure, the integrated circuit die of the communication chip includes one or more transistor architectures utilizing IC structures with topological crack stop features, in accordance with implementations of embodiments of the disclosure.

In further implementations, another component housed within the computing device 600 may contain an integrated circuit die that includes one or more transistor architectures utilizing IC structures with topological crack stop features, in accordance with implementations of embodiments of the disclosure.

In various implementations, the computing device 600 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 600 may be any other electronic device that processes data.

Thus, embodiments described herein include architectures utilizing IC structures with topological crack stop features.

## Claims

1. An integrated circuit structure, comprising:
one or more first level interconnects, FLIs (306), embedded in an underfill, UF, over a substrate (304);
an etch stop layer (308) over the FLIs (306);
a passivation layer (310) over the etch stop layer (308);
a plurality of vias (312) through the passivation layer (310);
a plurality of contacts (314) on the passivation layer (310) in contact with the plurality vias (312) to connect with the FLI; and
a plurality of topological crack stop, TCS, features (316) formed in the passivation layer (310) and on a top surface of the etch stop layer (308), **characterized in that** at least one of the TCS features (316) incorporates a metal insulator metal, MIM.

2. The integrated circuit structure of claim 1, wherein there is a correlation between a pitch and location of the FLIs (306) and a pitch and location of the TCS features (316).

3. The integrated circuit structure of claim 1 or 2, wherein the TCS features (316) have a shape that is square, rectangular, domed, saw-toothed, recess domed, trenched, or a combination thereof.

4. The integrated circuit structure of claim 1, 2 or 3, wherein at least a portion of the TCS features (316) are spaced apart between neighboring sets of the plurality of vias (312).

5. The integrated circuit structure of claim 1, 2, 3 or 4, wherein at least a portion of the TCS features (316) are located adjacent to ones of the plurality of vias (312) and directly under corresponding ones of the plurality of contacts (314).

6. The integrated circuit structure of claim 1, 2, 3 or 4, wherein the passivation layer (310) comprises a nitride and the TCS features (316) comprise an oxide.

7. The integrated circuit structure of anyone of claims 1 to 6, wherein at least a portion of the TCS features (316) comprise inductor elements that surround a base of one or more of the plurality of vias (312), and wherein a diameter of the at least a portion of the TCS features (316) is greater than a diameter of the corresponding contacts (314) located over the at least one of the plurality of vias (312).

8. The integrated circuit structure of anyone of claims 1 to 7, wherein at least a portion of the TCS features (316) are used as in-die alignment features.

9. The integrated circuit structure of anyone of claims 1 to 8, wherein at least a portion of the TCS features (316) are used as underfill adhesion promoters.

10. A method of fabricating topological crack stop, TCS, features on a structure comprising a first level interconnects embedded in an underfill over a substrate (304), and an etch stop layer (308) over the first layer interconnect, the method comprising:
forming a TCS layer over the etch stop layer (308);
forming a TSC layer pattern on the TCS layer;
etching trenches in the TCS layer within openings in the TSA layer pattern to form the TCS features (316), wherein at least one of the TCS features (316) incorporates a metal insulator metal, MIM;
patterning and depositing a passivation layer (310) over the TCS layer and etching via trenches in the passivation layer (310); and
performing via metallization in the via trenches to form vias (312) and performing contact metallization over the vias (312) to form contacts (314).

11. The method of claim 10, further comprising using a nitride as the TCS layer, and forming the TCS layer to a thickness of approximately 2 µm and forming the trenches in the TCS layer to a thickness of approximately 1.5 µm.

## Patentansprüche

1. Integrierte Schaltungsstruktur, umfassend:
ein oder mehrere First-Level-Interconnects, FLIs (306), die in einer Unterfüllung, UF, über einem Substrat (304) eingebettet sind;
eine Ätzstoppschicht (308) über den FLIs (306);
eine Passivierungsschicht (310) über der Ätzstoppschicht (308);
eine Mehrzahl von Vias (312) durch die Passivierungsschicht (310);
eine Mehrzahl von Kontakten (314) auf der Passivierungsschicht (310) in Kontakt mit der Mehrzahl von Vias (312) zur Verbindung mit dem FLI; und
eine Mehrzahl von topologischen Rissstopp- bzw. TCS-Merkmalen (316), die in der Passivierungsschicht (310) und auf einer oberen Oberfläche der Ätzstoppschicht (308) gebildet sind, **dadurch gekennzeichnet, dass** mindestens eines der TCS-Merkmale (316) ein Metall-Isolator-Metall, MIM, enthält.

2. Integrierte Schaltungsstruktur nach Anspruch 1, wobei eine Korrelation zwischen einem Rastermaß und einer Position der FLIs (306) und einem Rastermaß und einer Position der TCS-Merkmale (316) besteht.

3. Integrierte Schaltungsstruktur nach Anspruch 1 oder 2, wobei die TCS-Merkmale (316) eine Form aufweisen, die quadratisch, rechteckig, gewölbt, sägezahnförmig, nach innen gewölbt, grabenförmig oder eine Kombination davon ist.

4. Integrierte Schaltungsstruktur nach Anspruch 1, 2 oder 3, wobei mindestens ein Teil der TCS-Merkmale (316) zwischen benachbarten Sätzen der Mehrzahl von Vias (312) beabstandet sind.

5. Integrierte Schaltungsstruktur nach Anspruch 1, 2, 3 oder 4, wobei mindestens ein Teil der TCS-Merkmale (316) angrenzend an einzelne der Mehrzahl von Vias (312) und direkt unter entsprechenden der Mehrzahl von Kontakten (314) angeordnet ist.

6. Integrierte Schaltungsstruktur nach Anspruch 1, 2, 3 oder 4, wobei die Passivierungsschicht (310) ein Nitrid umfasst und die TCS-Merkmale (316) ein Oxid umfassen.

7. Integrierte Schaltungsstruktur nach einem der Ansprüche 1 bis 6, wobei mindestens ein Teil der TCS-Merkmale (316) Induktivitätselemente umfasst, die eine Basis eines oder mehrerer der Mehrzahl von Vias (312) umgeben, und wobei ein Durchmesser des mindestens einen Teils der TCS-Merkmale (316) größer als ein Durchmesser der entsprechenden Kontakte (314) ist, die über dem mindestens einen der mehreren Vias (312) angeordnet sind.

8. Integrierte Schaltungsstruktur nach einem der Ansprüche 1 bis 7, wobei mindestens ein Teil der TCS-Merkmale (316) als In-Die-Ausrichtungsmerkmale verwendet wird.

9. Integrierte Schaltungsstruktur nach einem der Ansprüche 1 bis 8, wobei mindestens ein Teil der TCS-Merkmale (316) als Unterfüllungsadhäsionsvermittler verwendet wird.

10. Verfahren zum Fertigen topologischer Rissstopp- bzw. TCS-Merkmale auf einer Struktur, die First-Level-Interconnects, die in einer Unterfüllung über einem Substrat (304) eingebettet sind, und eine Ätzstoppschicht (308) über dem First-Layer-Interconnect, umfasst, wobei das Verfahren Folgendes umfasst:
Bilden einer TCS-Schicht über der Ätzstoppschicht (308);
Bilden eines TSC-Schicht-Musters auf der TCS-Schicht;
Ätzen von Gräben in der TCS-Schicht innerhalb von Öffnungen in dem TSA-Schicht-Muster, um die TCS-Merkmale (316) zu bilden, wobei mindestens eines der TCS-Merkmale (316) ein Metall-Isolator-Metall, MIM, beinhaltet;
Strukturieren und Abscheiden einer Passivierungsschicht (310) über der TCS-Schicht und Ätzen von Via-Gräben in der Passivierungsschicht (310); und
Durchführen einer Via-Metallisierung in den Via-Gräben, um Vias (312) zu bilden, und Durchführen einer Kontaktmetallisierung über den Vias (312), um Kontakte (314) zu bilden.

11. Verfahren nach Anspruch 10, ferner umfassend Verwenden eines Nitrids als die TCS-Schicht und Bilden der TCS-Schicht bis zu einer Dicke von ungefähr 2 µm und Bilden der Gräben in der TCS-Schicht bis zu einer Dicke von ungefähr 1,5 µm.

## Revendications

1. Structure de circuit intégré, comprenant :
une ou plusieurs interconnexions de premier niveau, First Level Interconnects FLIs, (306), incorporées dans un remplissage sous-jacent, UnderFill UF, par-dessus un substrat (304) ;
une couche d'arrêt de gravure (308) par-dessus les FLIs (306) ;
une couche de passivation (310) par-dessus la couche d'arrêt de gravure (308) ;
une pluralité de trous d'interconnexion (312) à travers la couche de passivation (310) ;
une pluralité de contacts (314) sur la couche de passivation (310) en contact avec la pluralité de trous d'interconnexion (312) pour se connecter à la FLI ; et
une pluralité de dispositifs d'arrêt de fissure topologique, Topological Crack Stop TCS, (316) formés dans la couche de passivation (310) et sur une surface supérieure de la couche d'arrêt de gravure (308), **caractérisée en ce qu'**au moins un des dispositifs TCS (316) incorpore un métal-isolant-métal, Metal Insulator Metal MIM.

2. Structure de circuit intégré de la revendication 1, dans laquelle il y a une corrélation entre un pas et un emplacement des FLIs (306) et un pas et un emplacement des dispositifs TCS (316).

3. Structure de circuit intégré de la revendication 1 ou 2, dans laquelle les dispositifs TCS (316) ont une forme qui est carrée, rectangulaire, en dôme, en dents de scie, en dôme en retrait, en tranchée, ou une combinaison de celles-ci.

4. Structure de circuit intégré de la revendication 1, 2, ou 3, dans laquelle au moins une partie des dispositifs TCS (316) est espacée entre des ensembles voisins de la pluralité de trous d'interconnexion (312).

5. Structure de circuit intégré de la revendication 1, 2, 3, ou 4, dans laquelle au moins une partie des dispositifs TCS (316) est placée de façon adjacente à des trous d'interconnexion de la pluralité de trous d'interconnexion (312) et directement sous des contacts correspondants de la pluralité de contacts (314).

6. Structure de circuit intégré de la revendication 1, 2, 3, ou 4, dans laquelle la couche de passivation (310) comprend un nitrure et les dispositifs TCS (316) comprennent un oxyde.

7. Structure de circuit intégré de l'une quelconque des revendications 1 à 6, dans laquelle au moins une partie des dispositifs TCS (316) comprend des éléments inducteurs qui entourent une base d'un ou de plusieurs de la pluralité de trous d'interconnexion (312), et dans laquelle un diamètre de l'au moins une partie des dispositifs TCS (316) est supérieur à un diamètre des contacts correspondants (314) situés par-dessus l'au moins un de la pluralité de trous d'interconnexion (312).

8. Structure de circuit intégré de l'une quelconque des revendications 1 à 7, dans laquelle au moins une partie des dispositifs TCS (316) est utilisée en tant que dispositifs d'alignement en puce.

9. Structure de circuit intégré de l'une quelconque des revendications 1 à 8, dans laquelle au moins une partie des dispositifs TCS (316) est utilisée en tant que promoteurs d'adhérence de remplissage sous-jacent.

10. Procédé de fabrication de dispositifs d'arrêt de fissure topologique, Topological Crack Stop TCS, sur une structure comprenant des interconnexions de premier niveau incorporées dans un remplissage sous-jacent par-dessus un substrat (304), et une couche d'arrêt de gravure (308) par-dessus l'interconnexion de première couche, le procédé comprenant :
la formation d'une couche TCS par-dessus la couche d'arrêt de gravure (308) ;
la formation d'un motif de couche TSC sur la couche TSC ; la gravure de tranchées dans la couche TCS à l'intérieur de ouvertures dans le motif de couche TSA pour former les dispositifs TCS (316), dans lequel au moins un des dispositifs TCS (316) incorpore un métal-isolant-métal, Metal Insulator Metal MIM ;
le façonnage en motif et le dépôt d'une couche de passivation (310) par-dessus la couche TCS et la gravure par l'intermédiaire de tranchées dans la couche de passivation (310) ; et
la réalisation de métallisation de trou d'interconnexion dans les tranchées de trou d'interconnexion pour former des trous d'interconnexion (312) et la réalisation de métallisation de contact par-dessus les trous d'interconnexion (312) pour former des contacts (314).

11. Procédé de la revendication 10, comprenant en outre l'utilisation d'un nitrure en tant que couche TCS, et la formation de la couche TCS jusqu'à une épaisseur d'approximativement 2 µm et la formation des tranchées dans la couche TCS jusqu'à une épaisseur d'approximativement 1,5 µm.
